# FASCICULE DE BREVET EUROPEEN

(11) **EP 3 729 924 B1**
(45) Date de publication et mention de la délivrance du brevet: **01.05.2024**
(21) Numéro de dépôt: 18815737.4
(22) Date de dépôt: 17.12.2018
(51) Int. Cl.: H05K 7/14

(54) **CHARGEUR À HAUTE TENSION EMBARQUÉ DANS UN VÉHICULE AUTOMOBILE ÉLECTRIQUE OU HYBRIDE INTÉGRANT UN DISPOSITIF DE FILTRAGE CAPACITIF**
HOCHSPANNUNGSLADEGERÄT AN BORD EINES HYBRID- ODER ELEKTROMOTORFAHRZEUGS MIT EINER KAPAZITIVEN FILTERVORRICHTUNG
HIGH-VOLTAGE CHARGER ON BOARD A HYBRID OR ELECTRIC MOTOR VEHICLE INCORPORATING A CAPACITIVE FILTERING DEVICE

(30) Priorité: 21.12.2017 FR 1762806
(43) Date de publication de la demande: 28.10.2020
(73) Titulaire: Ampere SAS, 92100 Boulogne-Billancourt (FR)
(72) Inventeur: BEUCHER, Christophe, 92140 Clamart (FR); VACHER, Olivier, 27800 Harcourt (FR)
(74) Mandataire: Renault Group
(86) Numéro de dépôt international: PCT/EP2018/085108
(87) Numéro de publication internationale: WO 2019/121444

(56) Documents cités:
- EP-A1- 2 346 152
- EP-A2- 2 469 997
- EP-A2- 2 876 984
- US-A1- 2017 149 349

## Description

La présente invention concerne le domaine des véhicules automobiles électriques ou hybrides comprenant un chargeur embarqué de forte puissance.

Plus particulièrement, la présente invention concerne un carter comprenant des éléments d'une électronique de puissance, tels qu'un redresseur, un convertisseur, et une inductance, éléments dudit chargeur à forte puissance. Le courant, monophasé ou triphasé, circule ainsi par le redresseur pour être découpé à une fréquence donnée, puis à travers l'inductance avant de circuler dans le convertisseur dit « boost ».

Actuellement, des signaux 12V dédiés à la régulation de la charge et du moteur sont disposés à l'intérieur de ce carter comptant l'ensemble des éléments formant l'électronique de puissance. Des essais de compatibilité électromagnétique indiquent que le réseau de bord 12V se trouve fortement perturbé par le réseau à haute tension.

En effet, en traversant cette zone d'électronique de puissance, les signaux 12V sont couplés à différents organes, tels que notamment le convertisseur, le redresseur, l'onduleur, les inductances, les capacités, etc...

Afin d'améliorer le comportement du système aux essais de compatibilité électromagnétique, il est connu d'utiliser un dispositif de filtrage comprenant une pluralité de capacités disposées entre les signaux 12V et la masse du véhicule pour atténuer ce couplage. Ainsi, sur chacun des signaux 12V, on met en place un dispositif de filtrage capacitif.

Le document EP2346152 divulgue un chargeur à haute tension embarqué dans un véhicule automobile électrique ou hybride comprenant un carter d'électronique de puissance comprenant une pluralité de modules de puissance et au moins un connecteur relié par au moins un signal 12V à au moins un des modules d'électronique de puissance.

Le document US2017149349 divulgue un bloc connecteur comportant un dispositif de filtrage capacitif permettant d'éviter que les perturbations générées par l'électronique de puissance d'un convertisseur ne se propagent vers l'extérieur, via la fiche de sortie du bloc connecteur.

L'invention vise à prévoir un système permettant de filtrer les perturbations générées à l'intérieur de l'ensemble du carter d'électronique de puissance, tout en limitant l'encombrement dans le compartiment moteur et donc sans augmenter les dimensions du carter d'électronique de puissance.

L'invention a pour objet un chargeur à haute tension embarqué dans un véhicule automobile électrique ou hybride comprenant un carter d'électronique de puissance comprenant une pluralité de modules d'électronique de puissance, au moins un connecteur 12V relié par un au moins un signal 12V au moins à un des modules d'électronique de puissance.

Le chargeur embarqué comprend un dispositif de filtrage capacitif disposé en amont du connecteur 12V dans l'épaisseur du carter d'électronique de puissance.

Ainsi, il est possible de filtrer les perturbations au plus proche du connecteur sans en augmenter l'encombrement.

Par chargeur à haute tension, on entend un chargeur fonctionnant entre 22kW et 43 kW.

Par modules d'électronique de puissance, on entend notamment et non exclusivement, un onduleur, un redresseur, un convertisseur, une capacité courant continu, une capacité courant alternatif, une inductance.

Par signal 12V, on entend tout câble passant à l'intérieur du carter de puissance et apte à relier un(des) connecteur(s) à des modules d'électronique de puissance pour transporter le signal moteur et le signal de charge.

Avantageusement, le dispositif de filtrage capacitif comprend un circuit imprimé sur lequel est fixée au moins une capacité.

Selon un mode de réalisation, le dispositif de filtrage capacitif comprend un dispositif de fixation du circuit imprimé apte à relier le circuit imprimé à la masse du véhicule par contact avec le carter d'électronique de puissance.

Le dispositif de fixation a, par exemple, la forme d'une bague de section rectangulaire et pourrait être réalisé en matériau métallique.

Avantageusement, au moins une des parois du dispositif de fixation comprend au moins une languette élastique en contact avec le carter d'électronique de puissance. La languette est élastique grâce à l'élasticité procurée par le matériau métallique.

Le dispositif de fixation est, par exemple, soudé au circuit imprimé. On évite ainsi l'ajout de visseries qui viserait à fixer une carte supplémentaire de filtrage à l'intérieur du chargeur.

Par exemple, le circuit imprimé est pourvu d'un perçage traversant pour le passage du signal 12V.

Selon un mode de réalisation, le dispositif de fixation comprend deux parties en forme de L comprenant chacune une première paroi et une deuxième paroi sensiblement perpendiculaire à la première paroi.

Par exemple, les premières parois sont sensiblement parallèles entre elles et les deuxièmes parois sont sensiblement parallèles entre elles. En variante, on pourrait prévoir que le dispositif de fixation soit réalisé en une seule partie. Dans ce mode de réalisation, la carte imprimée est montée de manière perpendiculaire aux premières parois des parties du dispositif de fixation.

La première paroi de chaque partie peut comprendre une patte de retenue du circuit imprimé, par exemple, soudée chacune audit circuit.

La languette élastique est, par exemple, attachée à ses deux extrémités à une ou deux premières parois du dispositif de fixation.

Selon un autre mode de réalisation, le dispositif de fixation comprend deux parties agencées de manière à entourer le circuit imprimé.

Par exemple, une première partie comprend une première paroi, parallèle au circuit imprimé, une deuxième paroi, s'étendant de manière sensiblement perpendiculaire à partir d'un premier côté latéral de la première paroi et au moins une languette s'étendant de manière sensiblement perpendiculaire à partir d'un deuxième côté latéral de la première paroi, opposé au premier côté latéral. L'ensemble des parois de la première partie présente ainsi la forme d'un U.

Par exemple, une deuxième partie comprend une première paroi, parallèle au circuit imprimé et à la première paroi de la première partie et au moins une languette s'étendant de manière sensiblement perpendiculaire à partir d'un côté latéral de la première paroi, en direction de la première partie. L'ensemble des parois de la deuxième partie présente ainsi la forme d'un L.

La languette de la première partie s'étend en direction de la deuxième partie.

En variante, on pourrait inverser les premières et deuxièmes parties. On pourrait également prévoir deux languettes sur la deuxième partie et une languette sur la première partie.

En variante, on pourrait prévoir que le dispositif de fixation soit réalisé en une seule partie.

Les languettes forment des pattes de retenue du circuit imprimé soudée chacune audit circuit.

Par exemple, chacune des deux premières parois du dispositif de fixation comprend une languette élastique s'étendant à partir desdites parois vers l'extérieur, c'est-à-dire vers le carter. La languette est attachée à ses deux extrémités à la paroi associée et est élastique grâce à l'élasticité procurée par le matériau métallique.

Selon un autre mode de réalisation, le chargeur haute tension comprend une pluralité de connecteurs 12V et une pluralité de dispositifs de filtrage capacitif, chacun des dispositifs de filtrage capacitif étant disposé en amont du connecteur 12V associé dans l'épaisseur du carter d'électronique de puissance.

Selon un second aspect, l'invention concerne un véhicule automobile électrique ou hybride comprenant un compartiment moteur comportant un chargeur embarqué à haute tension tel que décrit précédemment.

D'autres buts, caractéristiques et avantages de l'invention apparaîtront à la lecture de la description suivante, donnée uniquement à titre d'exemple non limitatif, et faite en référence aux dessins annexés, sur lesquels :
- la figure 1 illustre, de manière schématique, la structure d'un chargeur embarqué à haute tension comprenant un dispositif de filtrage capacitif selon un mode de réalisation de l'invention ;
- les figures 2 et 3 représentent en perspective, un dispositif de filtrage capacitif selon la figure 1 ; et

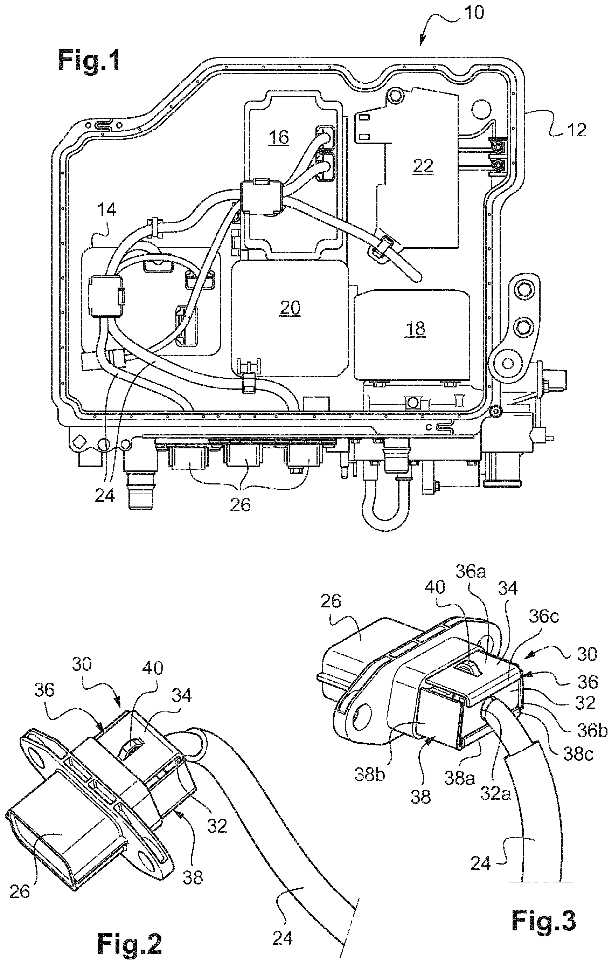

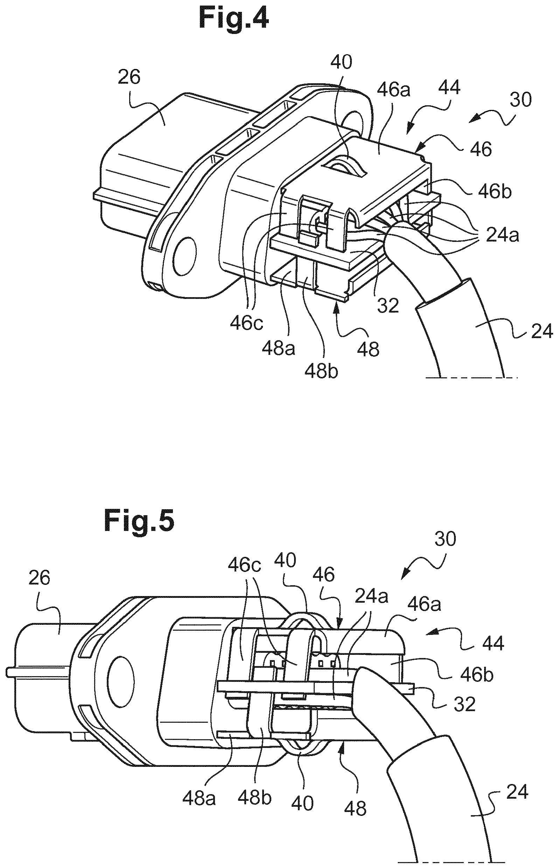

- les figures 4 et 5 représentent en perspective, un dispositif de filtrage capacitif selon un autre mode de réalisation de l'invention. Tel qu'illustré sur la figure 1, un chargeur embarqué à haute tension, par exemple de 43 kW, référencé 10 dans son ensemble destiné à être disposé dans le compartiment moteur d'un véhicule électrique ou hybride, comprend un carter 12 d'électronique de puissance à l'intérieur duquel sont disposés des modules d'électronique de puissance, tels que notamment et non exclusivement, un onduleur 14, un redresseur 16, un convertisseur 18, une capacité courant continu 20 et une capacité courant alternatif 22.

Tel qu'illustré, une pluralité de câblages 12V, référencés 24, sont disposés à l'intérieur dudit carter d'électronique de puissance, reliés à des connecteurs 12V, référencés 26, afin de câbler le signal moteur et le signal de charge.

Le chargeur embarqué 10 comporte en outre des dispositifs de filtrage capacitif 30 illustré en détails sur les figures 2 et 3. Chacun des dispositifs de filtrage capacitif 30 est disposé à proximité immédiate de chacun des connecteurs 26, en amont du connecteur correspondant, c'est-à-dire entre le connecteur et l'intérieur du carter. Les dispositifs de filtrage capacitif 30 sont intégrés dans l'épaisseur du carter d'électronique de puissance 12.

Chacun des dispositifs de filtrage capacitif 30 comprend un circuit imprimé 32, ou printed circuit board, « PCB » en termes anglo-saxons sur lequel sont fixées une ou plusieurs capacités (non représentées). Tel qu'illustré, le circuit imprimé 32 présente la forme générale d'une plaque pourvue d'un perçage 32a traversant pour le passage du câblage 12V correspondant.

Chacun des dispositifs de filtrage capacitif 30 comprend en outre un dispositif de fixation 34 du circuit imprimé 32 sous la forme d'une bague de section rectangulaire. La bague 34 est réalisée en matériau métallique.

Telle qu'illustré, la bague 34 comprend deux parties 36, 38 en forme de L comprenant chacune une première paroi 36a ; 38a et une deuxième paroi 36b ; 38b sensiblement perpendiculaire à la première paroi 36a ; 38a. Les premières parois 36a, 38a sont sensiblement parallèles entre elles et les deuxièmes parois 36b, 38b sont sensiblement parallèles entre elles. En variante, on pourrait prévoir que la bague 34 soit réalisée en une seule partie. Telle qu'illustrée, la carte imprimée 32 est montée de manière perpendiculaire aux premières parois 36a et 38a des parties 36 et 38 de la bague 34.

La première paroi 36a ; 38a de chaque partie 36 ; 38 comprend une patte 36c ; 38c de retenue du circuit imprimé 32 soudée chacune audit circuit.

Tel qu'illustré, une des parois 36a de la bague comprend une languette 40 s'étendant à partir de ladite paroi 36a vers l'extérieur, c'est-à-dire vers le carter 12. La languette 40 est attachée à ses deux extrémités à la paroi et est élastique grâce à l'élasticité procurée par le matériau métallique. On comprend qu'une des sorties de la capacité disposée sur le circuit imprimé 32 est connectée à la masse par son contact avec la bague 34 sur une première ou deuxième paroi d'une des parties 36 ou 38, l'autre sortie étant connectée au câble 12V 24 au niveau du perçage 32a où ledit câble 24 est dénudé. Dans le mode de réalisation en référence aux figures 2 et 3, le câble ou câblage 12V est sous la forme d'un seul signal 12V.

Le mode de réalisation illustré sur les figures 4 et 5, dans lequel les mêmes éléments portent les mêmes références, diffère du mode de réalisation illustré sur les figures 2 et 3 par le fait que le câble 12V 24 comporte plusieurs signaux 12V 24a et par la forme du dispositif de filtrage capacitif 30.

De manière similaire au mode de réalisation précédent, le dispositif de filtrage capacitif 30 comprend un circuit imprimé 32 dit « PCB » sur lequel sont fixées une ou plusieurs capacités (non représentées).

Tel qu'illustré sur les figures 4 et 5, chacun des dispositifs de filtrage capacitif 30 comprend en outre un dispositif de fixation 44 du circuit imprimé 32 réalisé en matériau métallique.

Tel qu'illustré, le dispositif de fixation 44 comprend deux parties 46, 48 agencées de manière à entourer ledit circuit imprimé 32.

La première partie 46 comprend une première paroi 46a, parallèle au circuit imprimé 32, une deuxième paroi 46b, s'étendant de manière sensiblement perpendiculaire à partir d'un premier côté latéral de la première paroi 46a et deux languettes 46c parallèles entre elles et s'étendant de manière sensiblement perpendiculaire à partir d'un deuxième côté latéral de la première paroi 46a, opposé au premier côté latéral. L'ensemble des parois 46a, 46b, 46c de la première partie 46 présente la forme d'un U.

La deuxième partie 48 comprend une première paroi 48a, parallèle au circuit imprimé 32 et à la première paroi 46a de la première partie 46, et une languette 48b s'étendant de manière sensiblement perpendiculaire à partir d'un côté latéral de la première paroi 48a, en direction de la première partie 46. L'ensemble des parois 48a, 48b de la deuxième partie 48 présente la forme d'un L.

Les deux languettes 46c de la première partie 46 s'étendent en direction de la deuxième partie 48.

En variante, on pourrait inverser les premières et deuxièmes parties. On pourrait également prévoir deux languettes sur la deuxième partie et une languette sur la première partie.

En variante, on pourrait prévoir que le dispositif de fixation 44 soit réalisé en une seule partie.

Les languettes 46c, 48b forment des pattes de retenue du circuit imprimé 32 soudée chacune audit circuit.

Tel qu'illustré, chacune des deux premières parois 46a, 48a du dispositif de fixation 44 comprend une languette 40 s'étendant à partir desdites parois 46a, 48a vers l'extérieur, c'est-à-dire vers le carter 12. La languette 40 est attachée à ses deux extrémités à la paroi associée et est élastique grâce à l'élasticité procurée par le matériau métallique.

On comprend qu'une des sorties de la capacité disposée sur le circuit imprimé 32 est connectée à la masse par son contact avec dispositif de fixation 44, l'autre sortie étant connectée à chaque signal 12V 24a du câble 12V 24. La connexion à chacun des signaux 12V 24a est réalisée par un procédé dit « insulation piercing crimp » en termes anglo-saxons, c'est-à-dire par perçage de l'isolant des signaux 12V par une pointe, par exemple, soudée directement sur le circuit imprimé 32. En variante, les fils des signaux 12V peuvent être, par exemple, dénudés partiellement et soudés sur le circuit imprimé 32.

Les capacités sont ainsi entre les signaux 12V 24a et la masse du véhicule. La masse du véhicule est équivalente au carter du chargeur, dans l'épaisseur duquel le filtrage capacitif est monté.

Le dispositif de fixation 44 est, lui aussi, soudé au circuit imprimé 32 sur une empreinte dédiée. Le routage du circuit imprimé 32 est fait de telle sorte que les capacités sont situées entre la reprise masse (soudure dispositif de fixation 44 sur circuit imprimé 32 et les signaux 12V 24a).

Ainsi, le dispositif de filtrage 30 s'interface entre un câblage et le connecteur correspondant sans modifier l'environnement et en utilisant l'élasticité d'une bague métallique pour relier le circuit imprimé à la masse du véhicule.

## Revendications

1. Chargeur à haute tension embarqué dans un véhicule automobile électrique ou hybride comprenant un carter d'électronique de puissance (12) comprenant une pluralité de modules d'électronique de puissance (14, 16, 18, 20, 22), au moins un connecteur (26) 12V relié par au moins un signal 12V (24) au moins à un des modules d'électronique de puissance, **caractérisé en ce qu'**il comprend un dispositif de filtrage capacitif (30) disposé en amont du connecteur (26) 12V dans l'épaisseur du carter d'électronique de puissance (12).

2. Chargeur selon la revendication 1, dans lequel le dispositif de filtrage capacitif (30) comprend un circuit imprimé (32) sur lequel est fixée au moins une capacité.

3. Chargeur selon la revendication 2, dans lequel le dispositif de filtrage capacitif (30) comprend un dispositif de fixation (34, 44) du circuit imprimé (32) apte à relier le circuit imprimé à la masse du véhicule par contact avec le carter d'électronique de puissance (12).

4. Chargeur selon la revendication 3, dans lequel le dispositif de fixation (34, 44) a la forme d'une bague de section rectangulaire.

5. Chargeur selon la revendication 3 ou 4, dans lequel le dispositif de fixation (34, 44) est réalisé en matériau métallique.

6. Chargeur selon l'une des revendications 3 à 5, dans lequel au moins une des parois (36a, 46a, 48a) du dispositif de fixation (34, 44) comprend au moins une languette élastique (40) en contact avec le carter d'électronique de puissance.

7. Chargeur selon l'une des revendications 3 à 6, dans lequel le dispositif de fixation (34, 44) est soudé au circuit imprimé (32).

8. Chargeur selon l'une quelconque des revendications précédentes, dans lequel le circuit imprimé (32) est pourvu d'un perçage (32a) traversant pour le passage du signal 12V (24).

9. Chargeur selon l'une des revendications 1 à 8, comprenant une pluralité de connecteurs 12V et une pluralité de dispositifs de filtrage capacitif (30), chacun des dispositifs de filtrage capacitif (30) étant disposé en amont du connecteur (26) 12V associé dans l'épaisseur du carter d'électronique de puissance (12).

10. Véhicule automobile électrique ou hybride comprenant un compartiment moteur comportant un chargeur embarqué à haute tension selon l'une des revendications 1 à 9.

## Patentansprüche

1. Hochspannungsladegerät, das in ein Elektro- oder Hybridkraftfahrzeug integriert ist, beinhaltend ein Leistungselektronikgehäuse (12), das eine Vielzahl von Leistungselektronikmodulen (14, 16, 18, 20, 22) beinhaltet, mindestens einen 12V-Verbinder (26), der durch mindestens ein 12V-Signal (24) mit mindestens einem der Leistungselektronikmodule verbunden ist, **dadurch gekennzeichnet, dass** es eine kapazitive Filtervorrichtung (30) beinhaltet, die stromaufwärts des 12V-Verbinders (26) in der Dicke des Leistungselektronikgehäuses (12) angeordnet ist.

2. Ladegerät nach Anspruch 1, wobei die kapazitive Filtervorrichtung (30) eine Leiterplatte (32) beinhaltet, auf der mindestens ein Kondensator befestigt ist.

3. Ladegerät nach Anspruch 2, wobei die kapazitive Filtervorrichtung (30) eine Vorrichtung zur Befestigung (34, 44) der Leiterplatte (32) beinhaltet, die dazu fähig ist, die Leiterplatte durch Kontakt mit dem Leistungselektronikgehäuse (12) mit der Masse des Fahrzeugs zu verbinden.

4. Ladegerät nach Anspruch 3, wobei die Befestigungsvorrichtung (34, 44) die Form eines Rings mit rechteckigem Querschnitt aufweist.

5. Ladegerät nach Anspruch 3 oder 4, wobei die Befestigungsvorrichtung (34, 44) aus einem metallischen Material hergestellt ist.

6. Ladegerät nach einem der Ansprüche 3 bis 5, wobei mindestens eine der Wände (36a, 46a, 48a) der Befestigungsvorrichtung (34, 44) mindestens eine elastische Lasche (40) in Kontakt mit dem Leistungselektronikgehäuse beinhaltet.

7. Ladegerät nach einem der Ansprüche 3 bis 6, wobei die Befestigungsvorrichtung (34, 44) an die Leiterplatte (32) geschweißt ist.

8. Ladegerät nach einem beliebigen der vorhergehenden Ansprüche, wobei die Leiterplatte (32) über eine Durchgangsbohrung (32a) für den Durchgang des 12V-Signals (24) verfügt.

9. Ladegerät nach einem der Ansprüche 1 bis 8, beinhaltend eine Vielzahl von 12V-Verbindern und eine Vielzahl von kapazitiven Filtervorrichtungen (30), wobei jede der kapazitiven Filtervorrichtungen (30) stromaufwärts des zugehörigen 12V-Verbinders (26) in der Dicke des Leistungselektronikgehäuses (12) angeordnet ist.

10. Elektro- oder Hybridkraftfahrzeug, beinhaltend einen Motorraum, der ein integriertes Hochspannungsladegerät nach einem der Ansprüche 1 bis 9 umfasst.

## Claims

1. High-voltage charger on board an electric or hybrid motor vehicle comprising a power electronics casing (12) comprising a plurality of power electronics modules (14, 16, 18, 20, 22), at least one 12 V connector (26) connected, by at least one 12 V signal (24), at least to one of the power electronics modules, **characterized in that** it comprises a capacitive filtering device (30) arranged upstream of the 12 V connector (26) in the thickness of the power electronics casing (12).

2. Charger according to Claim 1, wherein the capacitive filtering device (30) comprises a printed circuit (32) on which at least one capacitor is fastened.

3. Charger according to Claim 2, wherein the capacitive filtering device (30) comprises a fastening device (34, 44) for the printed circuit (32) able to connect the printed circuit to the ground of the vehicle through contact with the power electronics casing (12).

4. Charger according to Claim 3, wherein the fastening device (34, 44) is in the form of a bushing with a rectangular cross section.

5. Charger according to Claim 3 or 4, wherein the fastening device (34, 44) is made from metallic material.

6. Charger according to one of Claims 3 to 5, wherein at least one of the walls (36a, 46a, 48a) of the fastening device (34, 44) comprises at least one elastic tab (40) in contact with the power electronics casing.

7. Charger according to one of Claims 3 to 6, wherein the fastening device (34, 44) is welded to the printed circuit (32).

8. Charger according to any one of the preceding claims, wherein the printed circuit (32) is provided with a through-hole (32a) for the 12 V signal (24) to pass through.

9. Charger according to one of Claims 1 to 8, comprising a plurality of 12 V connectors and a plurality of capacitive filtering devices (30), each of the capacitive filtering devices (30) being arranged upstream of the associated 12 V connector (26) in the thickness of the power electronics casing (12).

10. Electric or hybrid motor vehicle comprising an engine compartment comprising a high-voltage on-board charger according to one of Claims 1 to 9.
